# EUROPÄISCHE PATENTSCHRIFT

(11) **EP 3 408 854 B1**
(45) Veröffentlichungstag und Bekanntmachung des Hinweises auf die Patenterteilung: **17.06.2020**
(21) Anmeldenummer: 17702767.9
(22) Anmeldetag: 25.01.2017
(51) Int. Cl.: H01C 1/144, H01C 17/00, H01C 17/22, H01C 17/28

(54) **HERSTELLUNGSVERFAHREN FÜR EINEN WIDERSTAND UND ENTSPRECHENDE HERSTELLUNGSANLAGE**
PRODUCTION METHOD FOR A RESISTOR AND CORRESPONDING PRODUCTION INSTALLATION
PROCÉDÉ DE FABRICATION D'UNE RÉSISTANCE ET INSTALLATION DE FABRICATION CORRESPONDANTE

(30) Priorität: 25.01.2016 DE 102016000751
(43) Veröffentlichungstag der Anmeldung: 05.12.2018
(73) Patentinhaber: Isabellenhütte Heusler GmbH & Co. Kg, 35683 Dillenburg (DE)
(72) Erfinder: ESCHER, Marcus, 35708 Haiger (DE); HARKE, Paul, 35683 Dillenburg (DE); HETZLER, Ullrich, 35688 Dillenburg-Oberscheld (DE); MARIEN, Jan, 35745 Herborn (DE)
(74) Vertreter: v. Bezold & Partner Patentanwälte - PartG mbB
(86) Internationale Anmeldenummer: PCT/EP2017/000085
(87) Internationale Veröffentlichungsnummer: WO 2017/129361

(56) Entgegenhaltungen:
- DE-A1- 4 243 349
- US-A1- 2009 272 169
- US-A1- 2010 236 054

## Beschreibung

Die Erfindung betrifft ein Herstellungsverfahren für einen elektrischen Widerstand, insbesondere für einen niederohmigen Strommesswiderstand. Weiterhin umfasst die Erfindung auch eine Herstellungsanlage zur Durchführung des erfindungsgemäßen Herstellungsverfahrens.

Aus EP 0 605 800 A1 (DE 42 43 349 A1) sind niederohmige Strommesswiderstände bekannt, die zur Strommessung entsprechend der bekannten Vierleitertechnik eingesetzt werden können. Hierbei wird der zu messende elektrische Strom durch den niederohmigen Strommesswiderstand geleitet, wobei der Spannungsabfall über dem Strommesswiderstand gemessen wird. Der gemessene Spannungsabfall entspricht dann gemäß dem ohmschen Gesetz dem zu messenden elektrischen Strom.

Weiterhin ist aus EP 0 605 800 A1 ein Herstellungsverfahren für einen solchen niederohmigen Strommesswiderstand bekannt. Dabei werden drei Materialbänder aus einem Leitermaterial (z. B. Kupfer) bzw. aus einem Widerstandsmaterial (z. B. Manganin®) entlang ihrer Längskanten zu einem Verbundmaterialband zusammengeschweißt, wobei sich das Materialband aus dem Widerstandsmaterial in der Mitte befindet. Anschließend werden dann die Strommesswiderstände aus dem Verbundmaterialband vereinzelt, was beispielsweise durch Stanzen erfolgen kann, wobei das Verbundmaterialband jeweils quer zur Bandlängsrichtung abgetrennt wird. Vor der Vereinzelung der einzelnen Strommesswiderstände aus dem Verbundmaterialband kann das Verbundmaterialband gewalzt werden, so dass es aufgrund der Dickenreduzierung länger und breiter wird, ohne hierdurch an mechanischer und elektrischer Qualität zu verlieren. Nach der Vereinzelung der einzelnen Strommesswiderstände von dem Verbundmaterialband muss dann noch der gewünschte Widerstandswert justiert werden, indem beispielsweise ein Abgleicheinschnitt in das Widerstandselement eingebracht wird.

Nachteilig an diesem bekannten Herstellungsverfahren ist die Tatsache, dass zur Einstellung des gewünschten Widerstandswerts ein Abgleicheinschnitt in das Widerstandselement eingebracht werden muss, da die vereinzelten Strommesswiderstände nach der Vereinzelung nur eine unzureichende Genauigkeit hinsichtlich des Widerstandswerts aufweisen.

Aus US 2014/0059838 A1 ist ein Herstellungsverfahren für Metallschichtwiderstände bekannt, bei dem die einzelnen Metallschichtwiderstände von einem Materialband abgetrennt werden. Hierbei kann der Widerstandswert der abgetrennten Metallschichtwiderstände gemessen werden. In Abhängigkeit von dem gemessenen Widerstandswert der abgetrennten Metallschichtwiderstände kann dann die Schnittbreite angepasst werden, um den gewünschten Widerstandwert der abgetrennten Metallschichtwiderstände einzustellen. Hierbei erfolgt die Messung also an den abgetrennten Metallschichtwiderständen und nicht an dem Materialband (Ausgangsteil). Darüber hinaus ist hierbei nur eine Anpassung der Schnittbreite vorgesehen, nicht dagegen des Abwalzgrads. Dieses bekannte Herstellungsverfahren ist deshalb noch nicht optimal.

Weiterhin ist aus US 2010/0176913 A1 ein Herstellungsverfahren für Chip-Widerstände bekannt. Auch hierbei werden die einzelnen Chip-Widerstände von einem Materialband abgetrennt, wobei der Widerstandswert der abgetrennten Chip-Widerstände eingestellt werden kann, indem die Dicke des Materialbandes entsprechend dem gewünschten Widerstandswert eingestellt wird. Es ist hierbei jedoch nicht vorgesehen, irgendwelche elektrische Messungen an dem Materialband vorzunehmen, um in Abhängigkeit von dem Messwert die Dicke des Materialbandes einzustellen. Auch dieses bekannte Herstellungsverfahren ist deshalb noch nicht optimal.

Aus US 2010/0236054 A1 ist ein ähnliches Herstellungsverfahren bekannt, bei dem die Stanzweite eingestellt werden kann, um den Wert der elektrischen Bauteilkenngröße einzustellen.

Schließlich ist zum allgemeinen technischen Hintergrund der Erfindung noch hinzuweisen auf US 2009/272169 A1.

Der Erfindung liegt deshalb die Aufgabe zugrunde, ein entsprechend verbessertes Herstellungsverfahren und eine entsprechende Herstellungsanlage zu schaffen.

Diese Aufgabe wird durch die technische Lehre der unabhängigen Patentansprüche gelöst.

Die Erfindung beruht auf der technisch-physikalischen Erkenntnis, dass das Walzen des Verbundmaterialbandes aufgrund der damit verbundenen Dickenreduzierung zu einer Änderung des elektrischen Widerstands des Verbundmaterialbands quer zur Bandlängsrichtung führt, was sich dann auch in einer entsprechenden Änderung des elektrischen Widerstands des vereinzelten Strommesswiderstands äußert. Die Erfindung umfasst deshalb die allgemeine technische Lehre, den Walzvorgang gezielt zu steuern bzw. zu regeln, um den gewünschten Widerstandswert einzustellen.

Das erfindungsgemäße Herstellungsverfahren sieht deshalb zunächst in Übereinstimmung mit dem Stand der Technik vor, dass ein plattenförmiges Ausgangsteil (z. B. ein Verbundmaterialband) für den Widerstand bereitgestellt wird, wobei das Ausgangsteil eine bestimmte Dicke und entsprechend der Dicke einen bestimmten Wert einer elektrischen Bauteilkenngröße (z. B. elektrischer Widerstand) aufweist.

In einem bevorzugten Ausführungsbeispiel der Erfindung handelt es sich bei dem plattenförmigen Ausgangsteil für den Widerstand um ein Verbundmaterialband, wie es beispielsweise aus EP 0 605 800 A1 bekannt ist, so dass der Inhalt dieser früheren Patentanmeldung der vorliegenden Beschreibung hinsichtlich des Aufbaus und der Herstellung des Verbundmaterialbands in vollem Umfang zuzurechnen ist.

Es besteht jedoch alternativ auch die Möglichkeit, dass das plattenförmige Ausgangsteil lediglich ein Rohteil (Nutzen) ist, von dem mehrere Widerstände abgetrennt werden können.

Ein anderes Beispiel für ein geeignetes Ausgangsteil ist eine Widerstandsfolie.

Bei der dickenabhängigen elektrischen Bauteilgröße kann es sich beispielsweise um den elektrischen Widerstand des Ausgangsteils handeln. Bei einem Verbundmaterialwand als Ausgangsteil ist die dickenabhängige elektrische Bauteilkenngröße dann vorzugsweise der elektrische Widerstand quer zur Bandlängsrichtung. Es ist jedoch alternativ auch möglich, dass die dickenabhängige elektrische Bauteilkenngröße der Flächenwiderstand des Ausgangsteils ist.

Weiterhin umfasst das erfindungsgemäße Herstellungsverfahren in Übereinstimmung mit dem Stand der Technik einen Verfahrensschritt, der das Walzen des Ausgangsteils mit einem bestimmten Abwalzgrad vorsieht, wobei sich die Dicke des Ausgangsteils entsprechend dem Abwalzgrad verringert und der Wert der Bauteilkenngröße entsprechend verändert. Das Walzen des Ausgangsteils führt also zu einer Dickenreduzierung des Ausgangsteils und damit zu einer Querschnittsänderung des Ausgangsteils, was sich in der Regel in einer entsprechenden Erhöhung des elektrischen Widerstands äußert.

Der im Rahmen der Erfindung verwendete Begriff eines Abwalzgrads beschreibt die Verringerung der Bauteildicke beim Walzen und wird üblicherweise in Prozent angegeben. Ein Abwalzgrad von 50% bedeutet dann beispielsweise, dass sich die Dicke des Ausgangsteils beim Walzen auf 50% der Ausgangsdicke reduziert. Ein Abwalzgrad von 20% bedeutet dagegen, dass sich die Dicke des Ausgangsteils beim Walzen auf 80% der Ausgangsdicke reduziert.

Das erfindungsgemäße Herstellungsverfahren zeichnet sich nun gegenüber dem Stand der Technik dadurch aus, dass die dickenabhängige elektrische Bauteilkenngröße (z. B. elektrischer Widerstand) an dem gewalzten Ausgangsteil gemessen wird, d. h. nach dem Walzen des Ausgangsteils. Bei einem Verbundmaterialband als Ausgangsteil kann beispielsweise der elektrische Widerstand des Verbundmaterialbands quer zur Bandlängsrichtung gemessen werden.

Darüber hinaus zeichnet sich das erfindungsgemäße Herstellungsverfahren gegenüber dem Stand der Technik dadurch aus, dass der Abwalzgrad in Abhängigkeit von der gemessenen elektrischen Bauteilkenngröße angepasst wird, damit die fertigen Widerstände möglichst exakt den gewünschten Widerstandswert aufweisen, so dass nach Möglichkeit auf die Einbringung eines normalerweise erforderlichen Abgleicheinschnitts verzichtet werden kann.

Falls die Widerstandsmessung an dem gewalzten Verbundmaterialband einen zu geringen Widerstandswert ergibt, so deutet dies auf einen zu geringen Abwalzgrad hin, d. h. das gewalzte Verbundmaterialband ist zu dick. In diesem Fall wird der Abwalzgrad etwas erhöht, um die Dicke zu verringern und damit den Widerstand des gewalzten Verbundmaterialbands entsprechend zu erhöhen.

Falls die Messung des Widerstands des gewalzten Verbundmaterialbandes dagegen einen zu großen Widerstand ergibt, so deutet dies auf eine zu geringe Dicke des gewalzten Verbundmaterialbands hin. In diesem Fall wird der Abwalzgrad entsprechend verringert, um ein dickeres Verbundmaterialband nach dem Walzen und einen entsprechend kleineren Widerstand zu erhalten.

Die Messung der dickenabhängigen elektrischen Bauteilkenngröße an dem gewalzten Ausgangsteil und die entsprechende Anpassung des Abwalzgrads erfolgt vorzugsweise kontinuierlich während des laufenden Herstellungsprozesses, so dass der IstWert der gemessenen Bauteilkenngröße innerhalb eines engen Toleranzbereichs um einen vorgegebenen Soll-Wert für die dickenabhängige elektrische Bauteilkenngröße gehalten wird.

Vorzugsweise erfolgt diese Anpassung des Abwalzgrads im Rahmen einer Regelung (d.h. mit einer Rückkopplungsschleife) mit der elektrischen Bauteilkenngröße als Regelgröße und dem Abwalzgrad als Stellgröße.

In dem bevorzugten Ausführungsbeispiel der Erfindung wird das Ausgangsteil in einer Walzstation gewalzt und die Bauteilkenngröße des gewalzten Ausgangsteils wird anschließend in einer Messstation gemessen. Hierbei wird das Ausgangsteil vorzugsweise von einer Fördereinrichtung erst durch die Walzstation und dann durch die Messstation gefördert.

Hierbei ist zu erwähnen, dass die Förderung des Ausgangsteils (z. B. Verbundmaterialband) durch die Walzstation und durch die Messstation vorzugsweise kontinuierlich erfolgt, d.h. nicht im Stopp-and-Go-Betrieb. Die dickenabhängige elektrische Bauteilkenngröße des Ausgangsteils wird dann vorzugsweise ohne Anhalten der Förderbewegung des Ausgangsteils in der Messstation gemessen, während das Ausgangsteil durch die Messstation gefördert wird.

Bei einem Verbundmaterialband als Ausgangsteil kann die Messung des elektrischen Querwiderstands des gewalzten Verbundmaterialbandes beispielsweise mittels Kontaktschleifern erfolgen, die das Verbundmaterialband auf den gegenüberliegenden Seiten elektrisch kontaktieren und dadurch eine Widerstandsmessung ermöglichen. Die Erfindung ist jedoch hinsichtlich des Messprinzips zur Messung des elektrischen Querwiderstands nicht auf dieses simple Beispiel beschränkt, sondern auch mit anderen Messprinzipien realisierbar.

Es wurde bereits vorstehend erwähnt, dass es sich bei dem Ausgangsteil vorzugsweise um ein Verbundmaterial handelt, wie es beispielsweise aus EP 0 605 800 A1 bekannt ist, wobei ein solches Verbundmaterialband aus mehreren Materialbändern besteht, die entlang ihrer Längskanten miteinander verbunden sind, insbesondere durch eine Schweißnaht (z. B. Elektronenstrahlschweißnaht). Beim Walzen des Verbundmaterialbands erfolgt dann nicht nur eine Dickenreduzierung, sondern auch eine relative Längung. Dies ist vorteilhaft, weil dadurch mit relativ kurzen Schweißnähten entlang der Bandlängsrichtung im gewalzten Zustand ein relativ langes Verbundmaterialband erzeugt werden kann. Hierbei ist zu berücksichtigen, dass die Erzeugung der Schweißnähte wesentlich teurer ist als das Walzen des Verbundmaterialbandes. Es ist deshalb ökonomisch, die Schweißnähte an einem relativ dicken und entsprechend kurzen Materialband zu erzeugen, um das Verbundmaterialband dann in die Länge zu walzen, um die gewünschte Länge zu erreichen. Die beim Walzen erreichte relative Längung des Verbundmaterialbandes beträgt deshalb vorzugsweise mindestens 20%, 50%, 100%, 200%, 300% oder sogar mindestens 400%.

Zu dem Verbundmaterialband ist weiterhin zu erwähnen, dass es sich beispielsweise um ein Tri-Band handeln kann, d.h. um ein Verbundmaterialband, das aus drei Materialbändern besteht, die entlang ihrer Längskanten miteinander verbunden sind, wobei die äußeren Materialbänder aus einem Leitermaterial (z. B. Kupfer) bestehen, während das mittlere Materialband aus einem Widerstandsmaterial (z. B. Manganin®) besteht.

Es ist jedoch alternativ auch möglich, dass das Verbundmaterialband ein Bi-Band ist, das aus zwei Materialbändern besteht, die entlang ihrer Längskanten miteinander verbunden sind, wobei das eine Materialband aus einem Leitermaterial (z. B. Kupfer) besteht, während das andere Materialband aus einem Widerstandsmaterial (z. B. Manganin®) besteht.

Es wurde bereits vorstehend auch schon erwähnt, dass es sich bei dem Ausgangsteil nicht notwendigerweise um ein Verbundmaterialband handeln muss. Es besteht beispielsweise auch die Möglichkeit, dass es sich bei dem Ausgangsteil um eine Widerstandsfolie handelt, die aus einem Widerstandsmaterial (z. B. Manganin®) besteht.

Bei einem Verbundmaterialband als Ausgangsteil wird als dickenabhängige elektrische Bauteilkenngröße vorzugsweise der elektrische Widerstand quer zur Bandlängsrichtung gemessen, wie bereits vorstehend kurz erwähnt wurde.

Auch bei dem erfindungsgemäßen Herstellungsverfahren erfolgt nach dem Walzen des Verbundmaterialbands vorzugsweise eine Vereinzelung der einzelnen Widerstände von dem Ausgangsteil in einer Vereinzelungsstation. Diese Vereinzelung kann beispielsweise durch Stanzen in einer Stanzstation erfolgen, wobei der abgetrennte Widerstand beispielsweise auch gebogen oder anderen Umformungsverfahren unterworfen werden kann.

So ist es bei dem Widerstand beispielsweise in der Regel nicht erforderlich, dass der Widerstand Abgleicheinschnitte aufweist, um den gewünschten Widerstandswert einzustellen. Die Einstellung des gewünschten Widerstandswerts kann nämlich bei dem Widerstand dadurch sichergestellt werden, dass der Abwalzgrad während des Herstellungsprozesses laufend angepasst wird.

Hierbei ist zu erwähnen, dass der Widerstand an seinen parallel zur Stromflussrichtung liegenden Seitenkanten in der Regel Stanzkanten aufweist, die von einem Ausstanzen aus einem Verbundmaterialband herrühren.

Der Widerstand weist also in der Regel zwei Anschlussteile aus einem Leitermaterial (z. B. Kupfer) auf, um den elektrischen Strom in den Widerstand einzuleiten bzw. aus dem Widerstand auszuleiten. In Stromflussrichtung zwischen diesen beiden Anschlussteilen ist ein Widerstandselement aus einem Widerstandsmaterial (z. B. Manganin®) angeordnet, so dass das Widerstandselement von dem zu messenden elektrischen Strom durchströmt wird. Das Widerstandselement ist hierbei durch Schweißnähte (z. B. Elektronenschweißnähte) mit den beiden Anschlussteilen verbunden, wobei die Schweißnähte gewalzt sind.

Hierbei ist zu erwähnen, dass das Leitermaterial der Anschlussteile einen kleineren spezifischen elektrischen Widerstand hat als das Widerstandsmaterial.

Ferner ist zu erwähnen, dass die Erfindung hinsichtlich des Widerstandsmaterials nicht auf Manganin® beschränkt ist. Beispielsweise kann es sich bei dem Widerstandsmaterial auch um eine andere Kupfer-Mangan-Legierung handeln oder um eine Chrom-Nickel-Legierung, wie beispielsweise eine Nickel-Chrom-Aluminium-Legierung. Andere Beispiele für ein Widerstandsmaterial sind eine Kupfer-Nickel-Legierung oder eine Kupfer-Chrom-Legierung.

Es ist jedoch zu erwähnen, dass das Widerstandsmaterial vorzugsweise einen spezifischen elektrischen Widerstand mit einer hohen Temperaturkonstanz aufweist, so dass der Temperaturkoeffizient des elektrischen Widerstands vorzugsweise kleiner ist als 5·10⁻⁴ K⁻¹, 2·10⁻⁴ K⁻¹, 1·10⁻⁴ K⁻¹ oder sogar 5·10⁻⁵ K⁻¹.

Der Widerstandswert des Widerstands ist vorzugsweise äußerst gering und kann beispielsweise kleiner sein als 1 Ω, 500 mQ, 250 mΩ, 125 mΩ, 50 mΩ, 25 mΩ, 10 mΩ, 5 mΩ, 2 mΩ oder sogar kleiner als 1 mΩ.

Das Leitermaterial hat dagegen einen spezifischen elektrischen Widerstand, der vorzugsweise kleiner ist als 10⁻⁵ Ωm, 10⁻⁶ Ωm oder 10⁻⁷ Ωm.

Das Widerstandsmaterial hat dagegen vorzugsweise einen spezifischen elektrischen Widerstand, der kleiner ist als 2·10⁻⁴ Ωm, 2·10⁻⁵ Ωm oder 2·10⁻⁶ Ωm.

Ferner ist zu erwähnen, dass die Anschlussteile und/oder das Widerstandselement wahlweise eben oder gebogen sein können.

Zu dem Walzvorgang ist zu erwähnen, dass der Widerstand an seinen gewalzten Oberflächen vorzugsweise eine geringe Oberflächenrauhigkeit aufweist, die sich durch eine Rauhzahl Rz<10µm, Rz<5µm, Rz<3µm, Rz<2µm oder Rz<1µm auszeichnet.

Schließlich umfasst die Erfindung auch eine entsprechende Herstellungsanlage zur Herstellung eines elektrischen Widerstands und insbesondere zur Durchführung des eingangs beschriebenen erfindungsgemäßen Herstellungsverfahrens.

Die erfindungsgemäße Herstellungsanlage umfasst zunächst eine Materialzuführung zur Zuführung eines plattenförmigen Ausgangsteils (z. B. Verbundmaterialbahn) für den Widerstand, wobei das Ausgangsteil eine bestimmte Dicke und entsprechend der Dicke einen bestimmten Wert einer dickenabhängigen elektrischen Bauteilkenngröße aufweist.

Darüber hinaus umfasst die erfindungsgemäße Herstellungsanlage in Übereinstimmung mit dem Stand der Technik eine Walzstation zum Walzen des plattenförmigen Ausgangsteils mit einem bestimmten Abwalzgrad, wobei sich die Dicke des Ausgangsteils entsprechend dem Abwalzgrad verringert und der Wert der dickenabhängigen elektrischen Bauteilkenngröße entsprechend verändert.

Die erfindungsgemäße Herstellungsanlage zeichnet sich nun gegenüber dem Stand der Technik durch eine zusätzliche Messstation aus, die den Wert der elektrischen Bauteilkenngröße an dem gewalzten Ausgangsteil misst.

Bei einem Verbundmaterialband als Ausgangsteil in der Messstation kann beispielsweise der elektrische Widerstand des gewalzten Verbundmaterialbands quer zur Bandlängsrichtung gemessen werden.

Darüber hinaus umfasst die erfindungsgemäße Herstellungsanlage auch eine Anpassungseinrichtung zum Anpassen des Abwalzgrads in Abhängigkeit von der gemessenen elektrischen Bauteilkenngröße, wobei die Anpassungseinrichtung beispielsweise einen Regler umfassen kann, der die elektrische Bauteilkenngröße als Messgröße misst und den Abwalzgrad als Stellgröße in Abhängigkeit von der gemessenen Soll-Ist-Abweichung einstellt.

Ferner umfasst die erfindungsgemäße Herstellungsanlage vorzugsweise eine Schweißstation zum Zusammenschweißen von mehreren Materialbändern entlang ihrer Längskanten zu einem Verbundmaterialband, das dann als Ausgangsteil für das erfindungsgemäße Herstellungsverfahren dient.

Weiterhin umfasst die erfindungsgemäße Herstellungsanlage vorzugsweise eine Vereinzelungsstation zum Abtrennen der einzelnen Widerstände von dem gewalzten Ausgangsteil. Beispielsweise kann es sich bei der Vereinzelungsstation um eine Stanzstation handeln, die von dem Verbundmaterialband einzelne Widerstände ausstanzt.

Schließlich kann die erfindungsgemäße Herstellungsanlage auch eine Fördereinrichtung aufweisen, um das Ausgangsteil (z. B. Verbundmaterialband) durch die Walzstation, die Messstation und/oder durch die Vereinzelungsstation zu fördern.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:
- Figur 1: eine schematische Darstellung einer erfindungsgemäßen Herstellungsanlage zur Herstellung von niederohmigen Strommesswiderständen,
- Figur 2: das erfindungsgemäße Herstellungsverfahren in Form eines Flussdiagramms, sowie
- Figur 3: eine Perspektivansicht eines Strommesswiderstands.

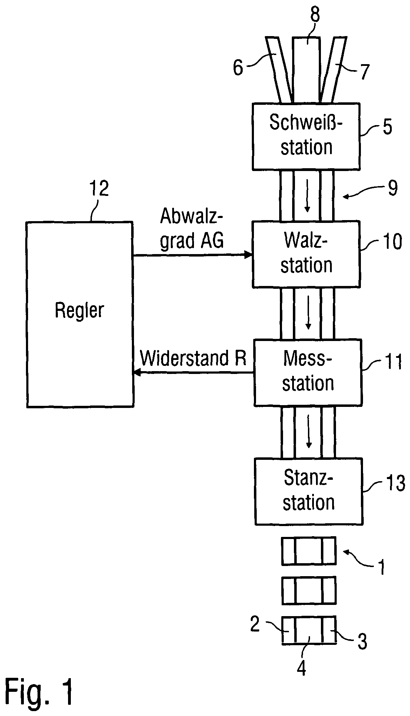

Figur 1 zeigt eine schematische Darstellung einer erfindungsgemäßen Herstellungsanlage zur Herstellung von niederohmigen Strommesswiderständen 1, wie sie an sich in ähnlicher Form bereits aus EP 0 605 800 A1 bekannt sind. So bestehen die Strommesswiderstände 1 aus zwei plattenförmigen Anschlussteilen 2, 3 aus Kupfer oder einem sonstigen Leitermaterial und einem Widerstandselement 4 aus einem Widerstandsmaterial, wie beispielsweise Manganin®. Das Widerstandselement 4 ist hierbei in Stromflussrichtung zwischen den beiden Anschlussteilen 2, 3 angeordnet, wobei die Anschlussteile 2, 3 dazu dienen, einen zu messenden elektrischen Strom in den Strommesswiderstand 1 einzuleiten bzw. aus dem Strommesswiderstand auszuleiten.

Zur Herstellung der Strommesswiderstände 1 werden einer Schweißstation 5 zwei Kupferbänder 6, 7 und ein Widerstandsband 8 zugeführt, die dann in der Schweißstation 5 entlang ihrer Bandlängskanten zu einem Verbundmaterialband 9 zusammengeschweißt werden, was an sich beispielsweise aus EP 0 605 800 A1 bekannt ist.

Das Verbundmaterialband 9 wird dann einer Walzstation 10 zugeführt, wobei die Walzstation 10 das Verbundmaterialband 9 mit einem einstellbaren Abwalzgrad AG walzt. Das Walzen des Verbundmaterialbandes 9 in der Walzstation 10 führt zu einer entsprechenden Dickenreduzierung des Verbundmaterialbands 9, was zu einer Querschnittsänderung und damit auch zu einer Änderung des Widerstands R quer zur Bandlängsrichtung führt.

Das gewalzte Verbundmaterialband 9 wird dann einer Messstation 11 zugeführt, die den elektrischen Widerstand R des Verbundmaterialbands 9 quer zur Bandlängsrichtung misst und an einen Regler 12 weiter gibt. Der Regler 12 regelt dann den Abwalzgrad AG kontinuierlich in Abhängigkeit von dem gemessenen Widerstand R, um den gemessenen Widerstand R auf einen vorgegebenen Soll-Wert einzuregeln.

Das Verbundmaterialband 9 wird dann schließlich einer Stanzstation 13 zugeführt, in der die einzelnen Strommesswiderstände 1 von dem Verbundmaterialband 9 abgetrennt werden.

Das geregelte Abwalzen des Verbundmaterialbandes 9 hat zur Folge, dass der Widerstandswert der vereinzelten Strommesswiderstände 1 äußerst exakt einem vorgegebenen Soll-Wert entspricht, so dass auf die ansonsten erforderliche Einbringung von Abgleicheinschnitten verzichtet werden kann.

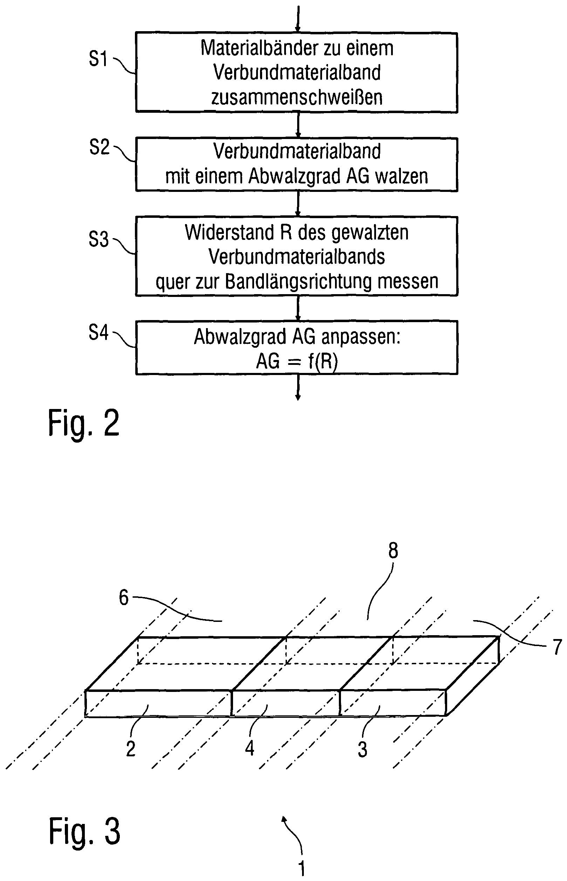

Figur 2 zeigt das erfindungsgemäße Herstellungsverfahren in Form eines Flussdiagramms.

In einem ersten Schritt S1 werden zunächst die beiden Kupferbänder 6, 7 mit dem Widerstandsband 8 zu dem Verbundmaterialband 9 zusammengeschweißt.

In einem zweiten Schritt S2 wird dann das Verbundmaterialband 9 mit dem vorgegebenen Abwalzgrad AG gewalzt.

Im nächsten Schritt S3 wird dann der Widerstand R des gewalzten Verbundmaterialbands 9 quer zur Bandlängsrichtung gemessen.

In einem weiteren Schritt S4 wird dann der Abwalzgrad AG in Abhängigkeit von dem gemessenen Widerstand R angepasst.

Die Verfahrensschritte S1-S4 werden hierbei im Rahmen des erfindungsgemäßen Herstellungsverfahrens kontinuierlich wiederholt.

### Bezugszeichenliste:

- 1: Strommesswiderstand
- 2: Anschlussteil
- 3: Anschlussteil
- 4: Widerstandselement
- 5: Schweißstation
- 6: Kupferband
- 7: Kupferband
- 8: Widerstandsband
- 9: Verbundmaterialband
- 10: Walzstation
- 11: Messstation
- 12: Regler
- 13: Stanzstation
- AG: Abwalzgrad
- R: Widerstand des Verbundmaterialbands quer zur Bandlängsrichtung

## Patentansprüche

1. Herstellungsverfahren für einen elektrischen Widerstand (1), insbesondere für einen niederohmigen Strommesswiderstand, mit den folgenden Schritten (S1-S4):
- Bereitstellen eines plattenförmigen Ausgangsteils (9) für den Widerstand (1), wobei das Ausgangsteil (9) eine bestimmte Dicke und entsprechend der Dicke einen bestimmten Wert einer elektrischen Bauteilkenngröße (R) aufweist, wobei die dickenabhängige elektrische Bauteilkenngröße (R) vorzugsweise der elektrische Widerstand (1) des Ausgangsteils (9), der Flächenwiderstand oder der Querwiderstand ist, und
- Walzen des Ausgangsteils (9) mit einem bestimmten Abwalzgrad (AG), wobei sich die Dicke des Ausgangsteils (9) entsprechend dem Abwalzgrad (AG) verringert und der Wert der Bauteilkenngröße (R) entsprechend verändert, **gekennzeichnet durch** folgende Schritte:
- Messen der dickenabhängigen elektrischen Bauteilkenngröße (R) an dem gewalzten Ausgangsteil (9), und
- Anpassen des Abwalzgrads (AG) in Abhängigkeit von der gemessenen elektrischen Bauteilkenngröße (R), insbesondere im Rahmen einer Regelung mit der elektrischen Bauteilkenngröße (R) als Regelgröße und dem Abwalzgrad (AG) als Stellgröße.

2. Herstellungsverfahren nach Anspruch 1,
**dadurch gekennzeichnet,**
a) **dass** das Ausgangsteil (9) in einer Walzstation (10) gewalzt wird,
b) **dass** die Bauteilkenngröße (R) des gewalzten Ausgangsteils (9) in einer Messstation (11) gemessen wird, und
c) **dass** das Ausgangsteil (9) von einer Fördereinrichtung erst durch die Walzstation (10) und dann durch die Messstation (11) gefördert wird.

3. Herstellungsverfahren nach Anspruch 2,
**dadurch gekennzeichnet,**
a) **dass** das Ausgangsteil (9) kontinuierlich durch die Walzstation (10) und dann durch die Messstation (11) gefördert wird, und
b) **dass** die dickenabhängige elektrische Bauteilkenngröße (R) des Ausgangsteils (9) ohne Anhalten der Förderbewegung des Ausgangsteils (9) in der Messstation (11) gemessen wird, während das Ausgangsteil (9) durch die Messstation (11) gefördert wird.

4. Herstellungsverfahren nach einem der vorhergehenden Ansprüche, **dadurch gekennzeichnet,**
a) **dass** das Ausgangsteil (9) ein Verbundmaterialband (9) ist, dass mindestens zwei Materialbänder (6, 7, 8) aufweist, die entlang ihrer Längskanten miteinander verbunden sind, insbesondere durch eine Schweißnaht, insbesondere durch eine Elektronenstrahlschweißnaht, und
b) **dass** das Verbundmaterialband (9) vorzugsweise in Bandlängsrichtung gewalzt wird, um das Verbundmaterialband durch das Walzen zu verlängern,
c) **dass** das Verbundmaterialband (9) durch das Walzen in Bandlängsrichtung mit einer relativen Längung gelängt wird, die vorzugsweise mindestens 20%, 50%, 100%, 200%, 300% oder 400% beträgt.

5. Herstellungsverfahren nach Anspruch 4,
**dadurch gekennzeichnet,**
a) **dass** das Verbundmaterialband (9) ein Tri-Band ist, das aus drei Materialbändern (6, 7, 8) besteht, die entlang ihrer Längskanten miteinander verbunden sind, wobei die äußeren Materialbänder (6, 7) aus einem Leitermaterial bestehen, während das mittlere Materialband (8) aus einem Widerstandsmaterial besteht, oder
b) **dass** das Verbundmaterialband (9) ein Bi-Band ist, das aus zwei Materialbändern besteht, die entlang ihrer Längskanten miteinander verbunden sind, wobei das eine Materialband aus einem Leitermaterial besteht, während das andere Materialband aus einem Widerstandsmaterial besteht, oder
c) **dass** das Ausgangsteil (9) eine Widerstandsfolie ist, die aus einem Widerstandsmaterial besteht.

6. Herstellungsverfahren nach einem der Ansprüche 4 oder 5, **dadurch gekennzeichnet,**
a) **dass** das Verbundmaterialband (9) in Bandlängsrichtung durch die Walzstation (10) und dann durch die Messstation (11) gefördert wird, und
b) **dass** in der Messstation (11) der elektrische Widerstand (1) quer zur Bandlängsrichtung gemessen wird.

7. Herstellungsverfahren nach einem der vorhergehenden Ansprüche, **gekennzeichnet durch** folgenden weiteren Schritt nach dem Walzen:
Abtrennen des Widerstands (1) von dem Ausgangsteil (9) in einer Vereinzelungsstation (13), insbesondere durch Stanzen in einer Stanzstation (13).

8. Herstellungsanlage zur Herstellung eines elektrischen Widerstands (1), insbesondere gemäß dem Herstellungsverfahren nach einem der Ansprüche 1 bis 7, mit
a) einer Materialzuführung zur Zuführung eines plattenförmigen Ausgangsteils (9) für den Widerstand (1), wobei das Ausgangsteil (9) eine bestimmte Dicke und entsprechend der Dicke einen bestimmten Wert einer dickenabhängigen elektrischen Bauteilkenngröße (R) aufweist, und
b) einer Walzstation (10) zum Walzen des plattenförmigen Ausgangsteils (9) mit einem bestimmten Abwalzgrad (AG), wobei sich die Dicke des Ausgangsteils (9) entsprechend dem Abwalzgrad (AG) verringert und der Wert der dickenabhängigen elektrischen Bauteilkenngröße (R) entsprechend verändert,
**gekennzeichnet durch**
c) eine Messstation (11) zum Messen der elektrischen Bauteilkenngröße (R) an dem gewalzten Ausgangsteil (9), und
d) eine Anpassungseinrichtung (12) zum Anpassen des Abwalzgrads (AG) in Abhängigkeit von der gemessenen elektrischen Bauteilkenngröße (R).

9. Herstellungsanlage nach Anspruch 8, **gekennzeichnet durch**
a) eine Schweißstation (5) zum Zusammenschweißen von mehreren Materialbändern (6, 7, 8) entlang ihrer Längskanten zu einem Verbundmaterialband (9), das als das Ausgangsteil (9) dient, und/oder
b) eine Vereinzelungsstation (13) zum Abtrennen der einzelnen Widerstände (1) von dem gewalzten Ausgangsteil (9), insbesondere in Form einer Stanzstation (13) zum Ausstanzen der einzelnen Widerstände aus dem Ausgangsteil (9), und/oder
c) eine Fördereinrichtung zum Fördern des Ausgangsteils (9) durch die Walzstation (10), die Messstation (11) und/oder durch die Vereinzelungsstation (13).

## Claims

1. Method for manufacturing an electrical resistor (1), in particular a low-resistance current measuring resistor, comprising the following steps (S1-S4):
- providing a plate-shaped base part (9) for the resistor (1), the base part (9) having a certain thickness and corresponding to the thickness a certain value of an electrical component characteristic (R), the thickness-dependent electrical component characteristic (R) preferably being the electrical resistance (1) of the base part (9), the sheet resistance or the transverse resistance, and
- rolling the base part (9) with a certain degree of rolling (AG), the thickness of the base part (9) decreasing in accordance with the degree of rolling (AG) and the value of the component characteristic (R) changing accordingly,
**characterized by** the following steps:
- measuring the thickness-dependent electrical component characteristic (R) on the rolled base part (9), and
- adaptation of the degree of rolling (AG) as a function of the measured electrical component characteristic (R), in particular in the context of a closed-loop control system with the electrical component characteristic (R) as controlled variable and the degree of rolling (AG) as control variable.

2. Method for manufacturing according to claim 1,
**characterized in that**
a) the base part (9) is rolled in a rolling station (10),
b) the component characteristic (R) of the rolled base part (9) is measured in a measuring station (11), and
c) the base part (9) is first conveyed by a conveying device through the rolling station (10) and then through the measuring station (11).

3. Method for manufacturing according to claim 2,
**characterized in that**
a) the base part (9) is continuously conveyed through the rolling station (10) and then through the measuring station (11), and
b) the thickness-dependent electrical component characteristic (R) of the base part (9) is measured without stopping the conveying movement of the base part (9) in the measuring station (11), while the base part (9) is conveyed through the measuring station (11).

4. Method for manufacturing according to one of the preceding claims, **characterized in that**
a) the base part (9) is a composite material strip (9) comprising at least two material strips (6, 7, 8) joined together along their longitudinal edges, in particular by a weld seam, in particular by an electron beam weld, and
b) the composite material strip (9) is preferably rolled in the longitudinal direction of the strip in order to extend the composite material strip through the rolling,
c) the composite material strip (9) is stretched by rolling in the longitudinal direction of the strip with a relative elongation which is preferably at least 20%, 50%, 100%, 200%, 300% or 400%.

5. Method for manufacturing according to claim 4,
**characterized in that**
a) the composite material strip (9) is a tri-band consisting of three material strips (6, 7, 8) joined together along their longitudinal edges, the outer material strips (6, 7) consisting of a conductor material, while the middle material strip (8) consists of a resistor material, or
b) the composite material strip (9) is a bi-band consisting of two material strips joined together along their longitudinal edges, one material strip consisting of a conductor material while the other material strip consists of a resistor material, or
c) the base part (9) is a resistance foil which consists of a resistor material.

6. Method for manufacturing according to any one of claims 4 or 5, **characterized in that**
a) the composite material strip (9) is conveyed in the longitudinal direction of the strip through the rolling station (10) and then through the measuring station (11), and
b) the electrical resistance (1) is measured in the measuring station (11) transversely to the longitudinal direction of the strip.

7. Method for manufacturing according to one of the preceding claims, **characterized by** the following further step after rolling:
separating the resistor (1) from the base part (9) in a separating station (13), in particular by punching in a punching station (13).

8. Manufacturing plant for producing an electrical resistor (1), in particular according to the manufacturing method according to one of claims 1 to 7, with
a) a material feed for feeding a plate-shaped base part (9) for the resistor (1), the base part (9) having a certain thickness and corresponding to the thickness a certain value of a thickness-dependent electrical component characteristic (R), and
b) a rolling station (10) for rolling the plate-shaped base part (9) with a certain degree of rolling (AG), wherein the thickness of the base part (9) is reduced in accordance with the degree of rolling (AG),
**characterised by**
c) a measuring station (11) for measuring the electrical component characteristic (R) on the rolled output part (9), and
d) an adaptation device (12) for adapting the degree of rolling (AG) as a function of the measured electrical component characteristic (R).

9. Manufacturing plant according to claim 8,
**characterised by**
a) a welding station (5) for welding together several material strips (6, 7, 8) along their longitudinal edges to form a composite material strip (9) which serves as the base part (9), and/or
b) a separating station (13) for separating the individual resistors (1) from the rolled base part (9), in particular in the form of a punching station (13) for punching out the individual resistors from the base part (9), and/or
c) conveying means for conveying the base part (9) through the rolling station (10), the measuring station (11) and/or the separating station (13).

## Revendications

1. Procédé de fabrication d'une résistance électrique (1), en particulier d'une résistance de mesure de courant de faible impédance, avec les étapes suivantes (S1-S4) :
- l'utilisation d'une pièce de départ (9) en forme de plaque pour la résistance (1), dans lequel la pièce de départ (9) présente une certaine épaisseur et une certaine valeur, correspondant à l'épaisseur, d'une caractéristique de composant électrique (R), dans lequel la caractéristique de composant électrique (R) dépendante de l'épaisseur, de préférence la résistance électrique (1) de la pièce de départ (9), est la résistance surfacique ou la résistance transversale, et
- le laminage de la pièce de départ (9) avec un certain degré d'aplanissement (AG), dans lequel l'épaisseur de la pièce de départ (9) est diminuée conformément au degré d'aplanissement (AG) et la valeur de la caractéristique de composant (R) est modifiée en conséquence,
**caractérisé par** les étapes suivantes :
- la mesure de la caractéristique de composant électrique (R) dépendante de l'épaisseur au niveau de la pièce de départ laminée (9), et
- l'adaptation du degré d'aplanissement (AG) en fonction de la caractéristique de composant électrique (R) mesurée, en particulier dans le cadre d'une régulation avec la caractéristique de composant électrique (R) en tant que variable commandée et avec le degré d'aplanissement (AG) en tant que variable réglante.

2. Procédé de fabrication selon la revendication 1, **caractérisé en ce**
a) **que** la pièce de départ (9) est laminée dans un poste de laminage (10),
b) **que** la caractéristique de composant (R) de la pièce de départ (9) laminée est mesurée dans un poste de mesure (11), et
c) **que** la pièce de départ (9) est transportée par un système de transport d'abord à travers le poste de laminage (10) et ensuite à travers le poste de mesure (11) .

3. Procédé de fabrication selon la revendication 2, **caractérisé en ce**
a) **que** la pièce de départ (9) est transportée continuellement à travers le poste de laminage (10) et ensuite à travers le poste de mesure (11), et
b) **que** la caractéristique de composant électrique (R) dépendante de l'épaisseur, de la pièce de départ (9), est mesurée sans arrêt du mouvement de transport de la pièce de départ (9) dans le poste de mesure (11) pendant que la pièce de départ (9) est transportée à travers le poste de mesure (11).

4. Procédé de fabrication selon l'une quelconque des revendications précédentes, **caractérisé en ce**
a) **que** la pièce de départ (9) est un ruban de matériau composite (9) qui comprend au moins deux rubans de matériau (6, 7, 8) qui sont reliés entre eux le long de leurs arêtes longitudinales, en particulier par un cordon de soudure, en particulier par un cordon de soudure de faisceau d'électrons, et
b) **que** le ruban de matériau composite (9) est laminé de préférence dans la direction de la longueur du ruban pour allonger le ruban de matériau composite par le laminage,
c) **que** le ruban de matériau composite (9) est allongé par le laminage en direction de la longueur du ruban d'un allongement relatif qui est de préférence au moins de 20 %, 50 %, 100 %, 200 %, 300 % ou 400 %.

5. Procédé de fabrication selon la revendication 4, **caractérisé en ce**
a) **que** le ruban de matériau composite (9) est un ruban triple qui se compose de trois rubans de matériau (6, 7, 8) qui sont reliés entre eux le long de leurs arêtes longitudinales, dans lequel les rubans de matériaux externes (6, 7) se composent d'un matériau conducteur tandis que le ruban de matériau central (8) se compose d'un matériau résistant, ou
b) **que** le ruban de matériau composite (9) est un ruban double qui se compose de deux rubans de matériau qui sont reliés entre eux par leurs arêtes longitudinales, dans lequel un ruban de matériau se compose d'un matériau conducteur tandis que l'autre ruban de matériau se compose d'un matériau résistant ou
c) **que** la pièce de départ (9) est un film résistant qui se compose d'un matériau résistant.

6. Procédé de fabrication selon l'une quelconque des revendications 4 ou 5, **caractérisé en ce**
a) **que** le ruban de matériau composite (9) est transporté dans la direction longitudinale du ruban à travers le poste de laminage (10) et ensuite à travers le poste de mesure (11), et
b) **que**, dans le poste de mesure (11), la résistance électrique (1) est mesurée transversalement à la direction longitudinale du ruban.

7. Procédé de fabrication selon l'une quelconque des revendications précédentes, **caractérisé par** les autres étapes suivantes après le laminage :
le détachement de la résistance (1) de la pièce de départ (9) dans une poste de séparation (13), en particulier par poinçonnage dans un poste de poinçonnage (13) .

8. Installation de fabrication pour la fabrication d'une résistance électrique (1), en particulier selon le procédé de fabrication selon l'une quelconque des revendications 1 à 7, avec
a) une amenée de matériau pour amener une pièce de départ (9) en forme de plaque pour la résistance (1), dans lequel la pièce de départ (9) présente une certaine épaisseur et une certaine valeur, correspondant à l'épaisseur, d'une caractéristique de composant électrique (R) dépendante de l'épaisseur, et
b) un poste de laminage (10) pour laminer la pièce de départ (9) en forme de plaque avec un certain degré d'aplanissement (AG), dans laquelle l'épaisseur de la pièce de départ (9) est diminuée conformément au degré d'aplanissement (AG) et la valeur de la caractéristique de composant électrique (R) dépendante de l'épaisseur est modifiée en conséquence,
**caractérisée par**
c) un poste de mesure (11) pour mesurer la caractéristique de composant électrique (R) au niveau de la pièce de départ (9) laminée, et
d) un système d'adaptation (12) pour adapter le degré d'aplanissement (AG) en fonction de la caractéristique de composant électrique (R) mesurée.

9. Installation de fabrication selon la revendication 8, **caractérisée par**
a) une station de soudure (5) pour souder ensemble plusieurs rubans de matériau (6, 7, 8) le long de leurs arêtes longitudinales en un ruban de matériau composite (9), qui sert de pièce de départ (9), et/ou
b) un poste de séparation (13) pour détacher les différentes résistances (1) de la pièce de départ (9) laminée, en particulier sous forme d'un poste de poinçonnage (13) pour séparer par poinçonnage les différentes résistances de la pièce de départ (9), et/ou
c) un système de transport pour transporter la pièce de départ (9) à travers le poste de laminage (10), le poste de mesure (11) et/ou à travers le poste de séparation (13).
